Europäisches Patentamt

European Patent Office

Office européen des brevets

(11) Veröffentlichungsnummer : **0 005 547**
**B1**

(12) **EUROPÄISCHE PATENTSCHRIFT**

(45) Veröffentlichungstag der Patentschrift :
02.12.81

(51) Int. Cl.³ : **H 01 L 31/16, H 01 C 10/00**

(21) Anmeldenummer : **79101514.2**

(22) Anmeldetag : **17.05.79**

(54) Optoelektrischer einstellbarer Spannungsteiler.

(30) Priorität : **23.05.78 DE 2822477**

(43) Veröffentlichungstag der Anmeldung :
**28.11.79 (Patentblatt 79/24)**

(45) Bekanntmachung des Hinweises auf die Patenterteilung : **02.12.81 Patentblatt 81/48**

(84) Benannte Vertragsstaaten :
**FR GB NL**

(56) Entgegenhaltungen :
**FR - A - 1 458 148**

(73) Patentinhaber : **Heimann GMBH**
**Weher Köppel 6**
**D-6200 Wiesbaden 1 (DE)**

(72) Erfinder : **Kunze, Claus, Dr., Dipl.-Phys.**
**Im Sonnental 19**
**D-6204 Taunusstein (DE)**
Erfinder : **Meyer, Jürgen, Dr.rer.nat.**
**Rhönstrasse 28**
**D-6204 Taunusstein 2 (DE)**
Erfinder : **Schaaf, Norbert**
**herweg 2**
**D-6200 Wiesbaden (DE)**

(74) Vertreter : **Mehl, Ernst, Dipl.-Ing.**
**Postfach 22 01 76**
**D-8000 München 22 (DE)**

Optoelektrischer einstellbarer Spannungsteiler

Die Erfindung betrifft einen optoelektrischen einstellbaren Spannungsteiler mit den Merkmalen entsprechend dem Oberbegriff des Anspruchs 1.

Klassische Potentiometer oder Spannungsteiler bestehen aus einem ohmschen Widerstandselement, gebildet aus einer Drahtwendel oder aus einem gestreckten Widerstandsdraht oder aus einer Widerstandsbahn. Das Element hat außen zwei elektrische Anschlüsse und dazwischen einen beweglichen Schleifkontakt als Abgriffelektrode. Der Schleifkontakt wird entweder über eine Schiebevorrichtung oder über eine Drehvorrichtung betätigt. Legt man an die äußeren Elektroden eine Spannung, dann teilt der Abgriff diese Spannung entsprechend seiner Stellung auf der Widerstandsbahn. Die Teilspannungen sind proportional den zwischen Abgriff und äußeren Elektroden liegenden Widerstandsteilen. Der gesamte ohmsche Widerstand bleibt dabei immer gleich. Solche klassischen Potentiometer haben den Nachteil, daß am Schleifkontakt ein Rauschen und Krachen entsteht und daß die Lebensdauer durch den Kontaktverschleiß begrenzt ist.

Um dieses zu verhindern, kann man den Abgriff kontaktlos gestalten. Man ersetzt entweder den Schleifkontakt durch eine andere Kontaktierung beispielsweise durch Belichtung der gewünschten Abgriffstelle in einer Fotoleiterschiene, die dann die Verbindung der zu kontaktierenden entsprechenden Stelle im Widerstandselement mit der Abgriffelektrode herstellt, oder man ändert den Widerstandswert von zwei Teilelementen mit festem Abgriffanschluß durch äußere Beeinflussung, beispielsweise durch ein Magnetfeld bei magnetfeldabhängigen Widerstandselementen. Im ersten Fall besteht der Nachteil, daß der aktivierte und den Kontakt zur Abgriffelektrode herstellende Teil der Fotoleiterschicht selbst einen Widerstandswert hat. Um zweiten Fall ist eine Linearität schwer herzustellen, insbesondere wenn zur Teilung der gewünschten elektrischen Größe eine an die gegenständliche Teileranordnung angeschlossene elektronische Schaltung benötigt wird.

Noch besser ist es, wenn man die Kontaktierung fest läßt und die Spannungsteilerwiderstände auf rein optoelektrischem Weg erzeugt. Ein solcher Spannungsteiler mit den eingangs genannten Merkmalen ist beispielsweise aus der franz. Patentschrift FR-A-1 458 148 bekannt. Durch laterales Verschieben eines Einstellelements läßt sich das Spannungsteilerverhältnis einstellen.

Der vorliegenden Erfindung liegt die Aufgabe zugrunde, die Einstellbarkeit bei einem solchen optoelektrischen einstellbaren Spannungsteiler zu verbessern.

Zur Lösung dieser Aufgabe werden bei einem Spannungsteiler der eingangs genannten Art erfindungsgemäß die Merkmale entsprechend dem Kennzeichen des Anspruchs 1 vorgeschlagen.

Die Einstellung des Spannungsteilerverhältnisses erfolgt durch eine Drehbewegung. Im Vergleich zu einer translatorischen Bewegung ist dies bedienungsfreundlicher. An sich ist dieser Typ von einstellbarem Spannungsteiler von den sog. Drehpotentiometern dem Fachmann geläufig.

Bei einem erfindungsgemäßen Spannungsteiler ist man in der Wahl des Funktionszusammenhanges zwischen Drehbewegung und Widerstandsteilerverhältnis völlig frei. Es braucht nur die Abgriffelektrode in Bezug auf die äußeren Elektroden einen entsprechenden Verlauf zu nehmen wie etwa nach einer logarithmischen Funktion. Im allgemeinen wird man einen linearen Zusammenhang zwischen Drehwinkel und Widerstandsteilerverhältnis wählen. Es lassen sich jedoch ohne technologischen Mehraufwand sog. Funktionspotentiometer herstellen, weil die Elektrodenstrukturen mit Hilfe von im allgemeinen fotolithografisch hergestellten Masken auf die Fotoleiterschicht aufgebracht werden, beispielsweise im Siebdruckverfahren oder aufgedampft werden.

Die Verstellung des Kreisausschnitts als belichtete Teilfläche der Fotoleiterschicht erfolgt durch Verdrehen einer Blende, vorteilhafterweise einer Kreissektorblende, koaxial zu den äußeren Elektroden. Die Belichtung erfolgt durch die Blende mit einer geeigneten Lichtquelle, beispielsweise eine Leuchtdiode. Zur gleichmäßigen Belichtung ist diese Lichtquelle vorteilhaft über einen Lichtleiter angeschlossen. Die Summe der Teilwiderstände bleibt unabhängig von der Stellung der belichteten Teilfläche konstant.

Nach einer vorteilhaften Ausgestaltung ist vorgesehen, daß ein linearer Zusammenhang zwischen der Drehung des belichteten Kreissektors und dem Widerstandsteilerverhältnis besteht und daß dazu der Radius der Abgriffelektrode einen von ihrem kleinsten Radius $r_0$, von ihrem größten Radius $r_1$ und vom Drehwinkel des Kreissektors ($\varphi$) abhängigen Verlauf nimmt nach der Formel

$$r = r_0 \exp \left( \frac{\varphi}{2\pi} \ln \frac{r_1}{r_0} \right).$$

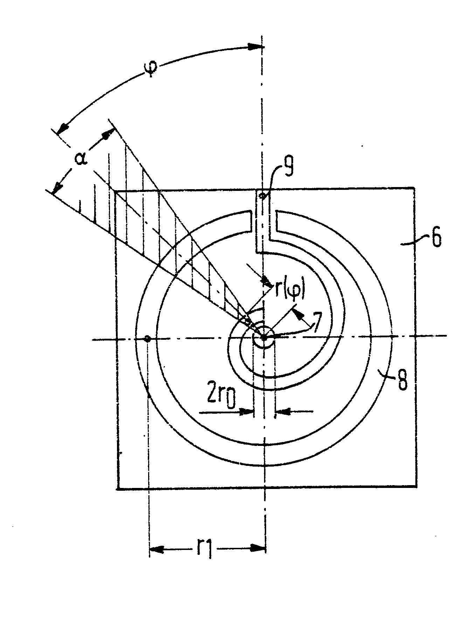

In der Zeichnung ist ein Ausführungsbeispiel der Erfindung als Drehpotentiometer dargestellt.

Mit 6 ist eine Fotoleiterschicht bezeichnet, die beispielsweise aus einer CdS-Schicht besteht, mit der ein Substrat wie beispielsweise schwarze oder weiße Keramik aus $Al_2O_3$ oder Glas beschichtet worden ist. Auf der Fotoleiterschicht 6 sind Leiterflächen beispielsweise durch Aufdampfen aufgebracht. Sie bestehen beispielsweise aus In oder Al oder einem anderen Metall, das mit CdS einen ohmschen Kontakt bildet.

Die Leiterflächen bilden zwei äußere Elektroden 7 und 8 und eine Abgriffelektrode 9. Die eine äußere Elektrode 7 sitzt punktförmig im Zentrum eines Kreises, der durch die andere äußere Elektrode 8 beschrieben wird. Dazwischen liegt die ausnutzbare Kreisfläche des Fotoleiters 6. Die Abgriffelektrode 9 beschreibt eine Bahn über den Winkel von 360° um den Mittelpunkt mit einer winkelabhängigen Funktion ihres Radius $r = f(\varphi)$ und ist durch einen Unterbrechungsspalt in der äußeren Elektrode 8 herausgeführt zur äußeren Kontaktierung. Eine solche Kontaktierung erfolgt zweckmäßig auch für die äußeren Elektroden 7 und 8 durch lasergebohrte Löcher durch das Substrat, auf das die Fotoleiterschicht 6 aufgebracht ist. Die Belichtung erfolgt beispielsweise über einen pyramidenförmigen Lichtleiter durch eine koaxial zu den äußeren Elektroden 7 und 8 drehbare Sektorenblende. Durch die Belichtung ist der Sektor der Fotoleiterschicht 6 elektrisch aktiviert und bildet für einen zwischen den beiden äußeren Elektroden 7 und 8 fließenden Strom einen ohmschen Widerstand, der durch die Abgriffelektrode 9 geteilt wird. In der Zeichnung ist der belichtete Sektor mit dem Öffnungswinkel $\alpha$ gestrichelt eingezeichnet, seine Winkelstellung in Bezug auf den Winkel der Herausführung der Abgriffelektrode 9 ist mit $\varphi$ bezeichnet. $r_0$ ist im wesentlichen der Radius der äußeren Elektrode 7, $r_1$ der der äußeren Elektrode 8.

Mit diesen Bezeichnungen läßt sich der Verlauf der Abgriffelektrode 9 zum Zweck einer linearen Abhängigkeit des Widerstandsteilerverhältnisses von der Drehstellung durch die Formel beschreiben

$$r(\varphi) = r_0 \exp\left(\frac{\varphi}{2\pi} \ln\frac{r_1}{r_0}\right) .$$

Für den ohmschen Widerstand zwischen der äußeren Elektrode 7 und Abgriffelektrode 9 gilt

$$R_1 = \frac{\rho}{\alpha \cdot \delta} \cdot \ln\frac{r}{r_0} = \frac{\rho}{\alpha \cdot \delta} \cdot \frac{\varphi}{2\pi} \cdot \ln\frac{r_1}{r_0}$$

mit $\delta$ als Dicke der Fotoleiterschicht 6 und $\rho$ als ihrem spezifischen Widerstand.

In der Praxis sind für einen exakten linearen Verlauf des Teilerverhältnisses in Abhängigkeit vom Drehwinkel $\varphi$ noch geringfügige empirische Korrekturen an den Elektroden 7, 8, 9 vorzunehmen, da die Abgriffelektrode 9 eine endliche Breite hat und innerhalb des Blendenwinkels nicht konzentrisch zu den äußeren Elektroden 7 und 8 ist.

**Ansprüche**

1. Optoelektrischer einstellbarer Spannungsteiler mit den Merkmalen :

a) als äußere Elektroden (7, 8) und als Abgriffelektrode (9) ohne galvanischen Schleifkontakt dienen Leiterbahnen auf einer Fotoleiterschicht (6), wobei die Leiterbahnen der beiden äußeren Elektroden einen konstanten Abstand voneinander aufweisen ;

b) als Spannungsteilerwiderstände dienen zwischen den Leiterbahnen liegende belichtete Teile der Fotoleiterschicht (6) ;

c) zur Einstellung des Spannungsteilers dient eine Verschiebung der belichteten Teile der Fotoleiterschicht (6), durch die sich das Abstandsverhältnis zwischen der Abgriffelektrode (9) und den beiden äußeren Elektroden (7, 8) ändert ; gekennzeichnet durch die folgenden Merkmale :

d) eine mit der Fotoleiterschicht (6) bedeckte, im Mittelpunkt einer Kreisfläche liegende, annähernd punktförmige Elektrodenfläche bildet die erste der beiden äußeren Elektroden (7) ;

e) die andere äußere Elektrode (8) ist eine dazu konzentrische Leiterbahn ;

f) die belichtete Fläche ist ein um die erste äußere Elektrode (7) drehbarer radialer Kreisausschnitt ;

g) die Abgriffelektrode (9) beschreibt eine Bahn zwischen den beiden äußeren Elektroden (7, 8), deren Radius eine Funktion des Drehwinkels ($\varphi$) des radialen Kreisausschittes ist.

2. Spannungsteiler nach Anspruch 1, dadurch gekennzeichnet, daß der Kreisausschnitt ein Kreissektor ist.

3. Spannungsteiler nach Anspruch 2, dadurch gekennzeichnet, daß ein linearer Zusammenhang zwischen der Drehung des belichteten Kreissektors und dem Widerstandsteilerverhältnis besteht und daß dazu der Radius der Abgriffelektrode (9) einen von ihrem kleisten Radius $r_0$, von ihrem größten Radius $r_1$ und vom Drehwinkel ($\varphi$) des Kreissektors abhängigen Verlauf nimmt nach der Formel

$$r = r_0 \exp\left(\frac{\varphi}{2\pi} \ln\frac{r_1}{r_0}\right) .$$

**Claims**

1. An optoelectric adjustable voltage divider having the features :

a) conductor paths on a photoconductor layer to serve as terminal electrodes (7, 8) and as a tapping electrode (9) without any galvanic sliding contact, the conductor paths of the two terminal electrodes having a constant mutual spacing ;

b) exposed parts of the photoconductor layer (6) which lie between the conductor paths serving as voltage divider resistors ;

c) a displacement of the exposed parts of the photoconductor layer (6) to change the distance ratio between the tapping electrode (9) and the two terminal electrodes (7, 8) serving to adjust the voltage dividers ; characterised by the following features :

d) a virtually punctiform electrode surface which is covered with the photoconductor layer and lies in the centre of a circular surface forms the first of the two terminal electrodes (7) ;

e) the other terminal electrode (8) is a conductor path which is concentric thereto ;

f) the exposed surface is a radial section which can be rotated about the first terminal electrode ;

g) the tapping electrode (9) describes a path between the two terminal electrodes (7, 8), the radius of which path is a function of the angle of rotation (φ) of the radial section.

2. A voltage divider as claimed in claim 1, characterised in that the section is a sector.

3. A voltage divider as claimed in claim 2, characterised in that there is a linear relationship between the rotation of the exposed circular sector and the resistor divider ratio, and that the radius of the tapping electrode (9) lies on a path which is dependent upon its smallest radius $r_0$, upon its largest radius $r_1$ and upon the angle of rotation (φ) of the sector, in accordance with the formula

$$r = r_0 \exp \left(\frac{\varphi}{2\pi} \ln \frac{r_1}{r_0}\right).$$

## Revendications

1. Diviseur de tension réglable par voie électrooptique du type mettant en œuvre :

a) comme électrodes d'extrémité (7, 8) et comme électrode de prise (9) sans contact glissant galvanique, des pistes conductrices ménagées sur une couche photoconductrice (6), les pistes conductrices des deux électrodes d'extrémité étant espacées l'une de l'autre d'une distance constante ;

b) comme résistances de diviseur de tension, des parties de la couche photoconductrice (6) éclairées et situées entre les pistes conductrices ;

c) pour le réglage du diviseur de tension, un déplacement des parties éclairées de la couche photoconductrice (6), à l'aide duquel est modifié le rapport des distances entre l'électrode de prise (9) et les deux électrodes d'extrémité (7, 8) caractérisé par les moyens suivants :

d) une surface d'électrode sensiblement ponctuelle, recouverte d'une couche photoconductrice (6) et située au centre d'une surface circulaire forme la première (7) des électrodes d'extrémité,

e) l'autre électrode d'extrémité (8) est constituée par une piste conductrice concentrique à ladite première électrode ;

f) la surface éclairée est formée par une section circulaire radiale tournant autour de la première électrode (7) ;

g) l'électrode de prise (9) décrit une trajectoire entre les deux électrodes d'extrémité (7, 8), dont le rayon est en fonction de l'angle de rotation (φ) de la section circulaire radiale.

2. Diviseur de tension selon la revendication 1, caractérisé par le fait que la section circulaire est un secteur de cercle.

3. Diviseur de tension selon la revendication 2, caractérisé par le fait qu'il existe une relation linéaire entre la rotation du secteur du cercle éclairé et le rapport du diviseur de tension, et que le rayon de l'électrode de prise (9) varie en fonction de son rayon le plus petit $r_0$, de son plus grand rayon $r_1$ et de l'angle de rotation (φ) dudit secteur, selon la relation

$$r = r_0 \exp \left(\frac{\varphi}{2\pi} \ln \frac{r_1}{r_0}\right).$$

1/1